# EUROPEAN PATENT APPLICATION

(11) **EP 3 620 809 A1**
(43) Date of publication of application: **11.03.2020**
(21) Application number: 19191992.7
(22) Date of filing: 15.08.2019
(51) Int. Cl.: G01R 35/00

(54) **TESTING APPARATUS FOR A VOLTAGE DETECTOR**

(30) Priority: 17.08.2018 GB 201813434
(71) Applicant: Powerpoint Engineering, R32 HH36 Portlaoise Co. Laois (IE)
(72) Inventor: Caldwell, Eoin, Limerick (IE); Liam, Davis, Portlaoise, Co. Laois (IE)
(74) Representative: Tomkins & Co

(57) **Abstract**

An apparatus for providing a high voltage, low energy output for proving a high voltage detector for testing voltages greater than 1000VAC; comprising;
an input (201) for receiving a low voltage direct current, DC input;
a modulation circuit (202) arranged to modulate the DC input and provide a first low voltage AC output (203);
a step up circuit (204) having an input for receiving the first low voltage AC output and an output (205) for outputting a second high voltage AC output; and
a feedback circuit configured to monitor the direct current input (201) and interrupt the input to the step-up circuit if an increase in the current input exceeds a threshold.

## Description

### Field of the Invention

Testing apparatus for a voltage detector and in particular a high voltage proving unit for high voltage test equipment.

### Background to the Invention

High voltage detection equipment is typically provided for the safe and practical detection of voltages in electrical media and high voltage systems, for example in power generation and distribution, the rail network, petrochemical and electrical service and maintenance industries. In all high voltage detection equipment and in the interest of safety, detectors must be proven or electrically tested with a known high voltage energy source to prove that they are functioning correctly. This requires the service provider to travel to a known high voltage high energy source and prove the functionality of the detector. Returning to the fault or the location of work, the service provider will then test for the presence of no voltage. However, to properly prove the unit, the service provider must travel back to the known high voltage, high energy source to make sure that the voltage detector did not fail in the test for the loss of voltage. If this subsequent test is passed then the service provider knows that there was no voltage at the fault or the location of work. These tests may be run in conjunction with audible and visible testing to check the voltage detector is correctly functioning via lights or buzzers for example. It is common practice then to return to the energy source to prove the functionality of the voltage detector so as to provide repeatability and functionality of the detector. This can result in a waste of time and resources. It is therefore desirable to provide a portable, repeatable and reliable known high voltage low energy source useable with capacitive or resistive type voltage detectors which can be used to test and prove the functionality of high voltage detectors on site and with high reliability.

### Summary of the Invention

The invention as described herein with reference to the appended claim is directed to an apparatus and a method for providing a high voltage, low energy output for proving a high voltage detector for testing high voltages.

An embodiment of the invention includes an apparatus for providing a high voltage, low energy output for proving a high voltage detector suitable for testing voltages greater than 1000VAC; comprising;
an input for receiving a low voltage direct current, DC input;
a modulation circuit arranged to modulate the DC input and provide a first low voltage alternating current, AC output;
a step up circuit having an input for receiving the first low voltage AC output and output a second high voltage AC output; and
a feedback circuit configured to monitor the direct current input and interrupt the input to the step-up circuit if an increase in the current input exceeds a threshold.

The apparatus as described above provides for simple and robust proving of a high voltage detector through the provision of an easily available testing point, with high voltage and low energy output, thus minimizing the risk to the operator of the test equipment. The monitoring circuit further provides additional safety and security to the equipment operator.

The step up circuit may comprise a first step up stage for receiving the first low voltage AC output and generating an intermediate voltage AC output and a second step up stage for generating the second high voltage AC output.

The two stage step up allows an intermediate tap to be included between the stages, the intermediate tap allowing a lower voltage AC output to be accessed for the testing of additional equipment.

The modulation circuit may comprises one or more pulse width modulation PWM, circuits and a microcontroller for controlling said PWM circuits.

The modulation circuit may be further configured to select an output frequency for the low voltage AC output.

The monitoring circuit may comprise a switch for interrupting input to the step-up circuit.

This switch provides for the many of the safety aspects of the monitoring circuit as described below.

The low voltage DC input may be in the range of 9VDC to 15VDC and preferably 12 VDC.

The low voltage DC input may be provided by a battery, and optionally wherein said battery is rechargeable. A DC input indicator may be provided for indicating the power level of the DC input.

The first low voltage AC output may be in the range of 7VAC to 12VAC and preferably 9VAC.

The second high voltage AC output may be in the region of 1000VAC up to 45kV and preferably 5000V.

The intermediate voltage AC output may be in the range of 110VAC to 230VAC.

The apparatus may further comprise an alternating current AC input and a converter for converting the AC input to the low voltage DC input.

The apparatus may further comprise a contact electrode for proving the high voltage detector & a ground electrode for the two pole type voltage detector.

The apparatus may further comprise a low voltage DC output for outputting a low voltage DC output from the modulation circuit.

The apparatus may further comprise one or more indicators for indicating functionality of the apparatus, each indicator comprising one or more light emitting diodes or visual outputs; audible outputs, etc.

A first indicator of the plurality of indicators may be configured to indicate the functionality of the feedback circuit and a second indicator of the plurality of indicators is configured to indicate the functionality of the step-up circuit.

The apparatus may further comprise a low voltage output for outputting a low voltage AC & DC output from the step up circuit.

The apparatus may be portable and/or handheld.

The apparatus may further comprise a delay timer for monitoring an operation delay and wherein the apparatus is configured to switch off if the operation delay exceeds a threshold.

### Brief Description of the Drawings

Various non-limiting embodiments of the technology described herein will not be described with specific reference to the following figures. It should be appreciated that the figures are not necessarily drawn to scale.
**Figure 1** is an overview of a first embodiment of a portable device in accordance with the present invention.
**Figure 2** is a block diagram of an embodiment of the apparatus in accordance with the present invention.
**Figure 3** is an extended block diagram of the embodiment of Figure 2 with a two stage step up.
**Figure 4** is a further extended block diagram of the embodiment of Figure 2 with a battery powered or mains input and additional jack outputs as shown in figure 1.
**Figure 5** is a block diagram of a monitoring circuit in accordance with the present application.

### Detailed Description of the Drawings

The aspects of the technology mentioned above, as well as additional aspects, will now be described in greater detail. The aspects may be used individually, all together or in any combination of two or more, as the technology is not limited in this respect.

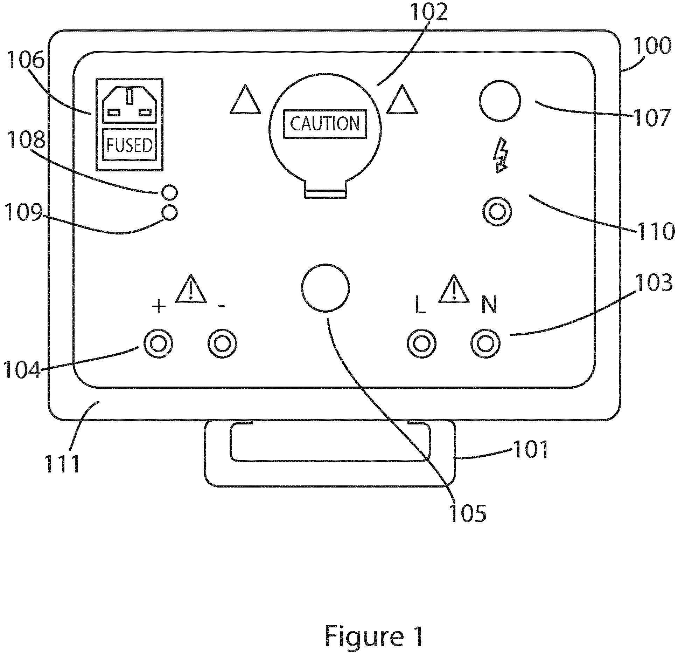

High voltage detectors often comprise separate rods and high voltage detectors. Examples of such detectors include Catu Detex cl 8-36. This is a resistive type, two pole high voltage detector. Other examples include HD Electric DVM II, also a resistive two pole high voltage detector or a Sofamel VTE -5/36U which is a capacitive, single pole high voltage detector. To replace current proving as described above, the user of the detector would prove that the high voltage detector is working, identify a loss of voltage at the fault or work location and subsequently, and conveniently at the work location re-prove that the high voltage detector is still working. The proving and re-proving are implementable with the apparatus described above in relation to Figure 1 and Figures 2 to 5 as described below. The apparatus described below provides a portable, repeatable and highly reliable low energy source for proving the detectors described above.

Figure 1 provides a possible configuration for an apparatus according to the present invention. The apparatus is a portable test equipment. The proving unit or apparatus 100 is provided in a casing 111. In an embodiment, the casing is manufactured from Peli 1300 Case & is an IP 67 water proof hard case with an air vent. It will be appreciated that the configuration of figure 1 is an example only and other configurations falling within the scope of the claims are envisaged. A handle 101 is provided for allowing portability and facilitating the handheld nature of this device. A high voltage output 102 is provided for allowing the user of the high voltage tester to access a high voltage low energy output from the proving unit to prove the functionality of the high voltage tester. This high voltage output is provided to a contact electrode. A cover is provided for the high voltage output/contact electrode to protect the contact points and also to provide additional safety. The cover can be lockable. It will be appreciated that two pole voltage detectors require a either a ground connection or a second electrode reference electrode output 110 is provided to allow the testing of such a two pole voltage detector. Considering a two probe resistive type voltage detectors having a primary pole and a secondary pole. It will be appreciated that to prove the two probe resistive detector, the primary pole would be contactable with output 102 & secondary pole is contactable with the second electrode reference output 110.

Additional outputs or terminals 103 and 104 are provided to increase the functionality of the testing unit. These are optional outputs. For example 103 may be output terminals or jacks which would allow access to a 220 V AC output. The output jacks 104 may be output points which would allow access to a 12VDC output. It will be appreciated that these are examples only and the jack outputs could be configured in alternate configurations. Optionally the jack outputs may be colour coded for positive and negative terminals. Similarly colour coding also allows the user of the proving/testing unit to readily recognise positive and negative terminals and/or the voltage rating.

Activating and deactivating the proving unit of figure 1 is with an on/off button 105. This can be any switch, button, or mechanism to activate or deactivate the proving unit. In the configuration shown the user of the proving unit activates/deactivates the proving unit by pressing the on/off button. While described above as a mechanical button, it will be appreciated that the on/off mechanism could be a switch, a toggle, a knob/dial or any other configuration of power switch having the same functionality. This is a potential safety feature provided so that the proving unit is not inadvertently left activated.

The on/off button 105 may be associated with a timer unit (not shown). The timer unit provides a time limit for activation of the proving unit.

In an example scenario, the on/off button 105 is used to activate the high voltage apparatus. Activating can mean energising all outputs so that the outputs are live. A timer may be initialised by setting the timer at a threshold time, for example 0 seconds, 1 minute or 45 seconds, or any other predefined time limit. This time threshold can be predefined at calibration or configuration of the proving unit or can be selected by an operator of the proving unit. The time threshold can also be set concurrently with the activation of the apparatus. On activation of the device the timer, depending on the configuration, may count up or down. This is a user configurable feature and can be set prior to use, or at configuration of the proving unit until the threshold is reached. Once the time reaches the threshold the proving unit would automatically deactivate or switch off. The outputs are de-energised, i.e. not live.

Indicator lights, for example LED lights 107 are optionally provided to indicate that outputs are activated or deactivated, depending on the colour of the LED. Alternatively an audible indicator may be provided. Additional indicators 107, 108, 109 are provided. For example, indicator 107 indicates that the high voltage output is energised. Indicator 108 indicates that a battery in the portable unit is charging. The indicators are optionally tricolour or other multicolour LED. The indicator 108 may also indicate that the mains supply is connected to the proving unit. The indicator 109 is a high voltage overload indicator and can be used to indicate that the high voltage unit has been deactivated or tripped due to overload of the system.

While it is appreciated that the example above is in relation to a high voltage detector, the outputs 103 and 104 as shown in Figure 1 further facilitate the provision of low voltage AC and DC outputs for the proving of low voltage AC and low voltage DC detectors. While shown in Figure 1 as part of the apparatus, it will be appreciated that one or both of these outputs 103, 104 may be provided with the high voltage output 102.

As further explained below the high voltage output may output for example 5kV AC at 50 HZ or at 60HZ. This high voltage low energy source provides a safe mechanism for a user to test voltage detectors at a convenient location. The low voltage AC output may output 220V AC at 50 Hz or at 60HZ and the low voltage DC output may, for example, output 12V DC. These are example values only and it will be appreciated that the present invention provides the scope for alternative values and outputs.

Considering an example only of the device in use, the user would access the high voltage output, for example where the cover is provided by unlocking the cover to expose the high voltage electrode 102. If no cover is provided or the cover has been removed, the user would have immediate access to the high voltage output electrode. The user would turn on the device via the on/off button 105. In a configuration where the apparatus is battery powered the user would confirm a status of the battery using the indicators 108. The pressing of the on off button may initiate the timer. It will be appreciated that there may be a second button for initiating the timer. Alternatively a first push of the on/off button may activate the device for test and a second push activate for timer initiation. The activation of the timer enables the high voltage output. Indicators 107 provide an audible or visible indication that the high voltage electrode is live. Once the high voltage electrode is energised, the high voltage detector may be touched or engaged with the electrode. If the detector fails to detect the presence of high voltage, then there is an error with the apparatus and the user would suspend test. If however a high voltage is detected the user will know that the detector is operating correctly in the presence of the high voltage field. Once it is proven that the detector is working correctly loss of voltage at the relevant fault site can be tested. If high voltages are detected then it will be appreciated that the user will know that the fault site is live and work must stop. If no high voltage is present at the relevant fault site, then the user would re-test the detector using the proving unit. The steps previously explained will be repeated. The ease of repeatability of testing and the convenience of the test unit provides a repeatable, reliable and convenient mechanism for high voltage detection.

It will be appreciated that low voltage AC can similarly be tested using the low voltage output 103 rather than the high voltage output 102. Similarly low voltage DC can be tested using the low voltage DC output 104.

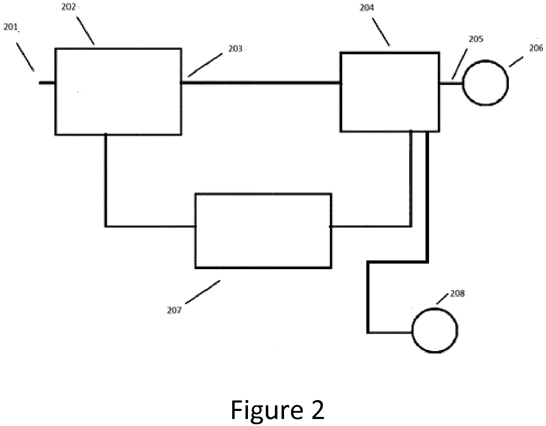

Figure 1 is an example of the casing of an example unit only. Figure 2 provides further detail of the apparatus and proving system as described below. A low voltage DC input 201 is provided to a modulation circuit 202 as identified in **figure 2**. The low voltage DC input may be derived directly from a DC battery or AC mains supply via an AC/DC inverter for mains isolation which will output the low voltage DC input.

The low voltage DC input is modulated by power transistors such as power mosfet or Insulated-gate bipolar transistors, IGBT. The power transistors switch on and off to convert the low voltage DC input to an AC output. The power transistors are controllable by a controller, for example a microcontroller having a pulse width modulation function, to convert the input from a DC waveform into an AC sinus waveform. This AC sinus waveform provides a first low voltage AC output 203. This first low voltage AC output 203 is provided to a step up circuit 204. The step up circuit in turn steps up the AC voltage from the low voltage AC at the first low voltage AC output 203 to a high voltage AC output at the output 205. This output is provided to the high voltage output 206 such as the high voltage output 102 of figure 1. Second Electrode reference output 208 is provided. This is equivalent to the second reference output 110 of the faceplate of figure 1.

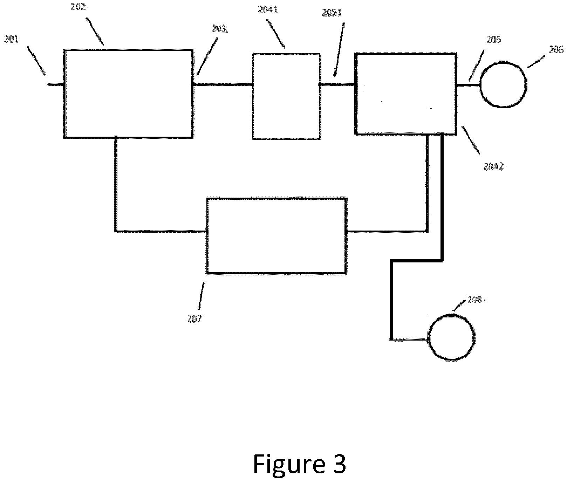

The step up circuit 204 can be a single stage step up or a multi-stage step up. For example, the first low voltage AC output 203 of the modulation circuit is provided to a first step up stage 2041. This first step up stage generates an intermediate voltage AC output 2051. This intermediate voltage AC output is provided to a second step up stage 2042 which generated the high voltage AC output 205. A two stage configuration is shown in figure 3.

The low voltage DC input is in the range of 9 V DC to 15VDC, for example approximately 12VDC. The first low voltage AC output from the modulation circuit 202 in one configuration is in the range of 7VAC to 12VAC and preferably 9VAC. The high voltage AC output at the output 205 in one embodiment is in the region of 1000VAC up to 45kV and preferably 5000VAC. With the provision of a two stage step up as described above the intermediate voltage AC output may be in the range of 110VAC to 230VAC, for example 220VAC.

A feedback circuit 207 is provided. The feedback circuit is configured to monitor the power levels at the step up transformer and feed back to the modulation circuit 202. This feedback circuit is a safety feature which will be described in further detail below.

The feedback circuit 207 is configured to monitor the current levels that are drawn from the battery for the mobile version, or to monitor the current drawn from the inverter for the mains feed fixed version. It will be appreciated that the feedback circuit is a safety feature to protect the operator if they touch the high voltage output / electrode 206.

The feedback circuit monitors the current that is drawn at the input 201 and if the circuit detects a draw greater than a threshold, for example 10 milliamps, it will switch off the output to the first low voltage AC output 203. The feedback circuit is also configured to de-energising the outputs 206 & 406 & 403. The feedback circuit may have primary and secondary feedback. The primary loop monitors the input 201. The secondary feedback loop is configured to monitor the output 205 to monitor the current flow to the output. The secondary feedback loop is configured to compare the monitored current flow to a threshold current level. If the current flow (milliamp current flow) is greater than a threshold, the outputs 204, 403, 406 are de-energised. The threshold may be set in software or preconfigured at calibration of the device. It will be appreciated that the secondary feedback loop may also activate the output or indicator 109 in figure 1. This will provide an indication to a user of the proving unit. This is a tripping scenario as described in relation to figure 1. In the event that the secondary feedback loop causes the proving unit to trip, the on off button or alternative reset button or input can be used to reset the proving unit.

The feedback circuit and secondary feedback loop may comprise one or more microcontrollers or other programmable device wherein inputs to the one or more microcontrollers are provided from the outputs 203 and 205. Threshold levels may be maintained in memory internal to the microcontroller or may be stored on external memory. The on off button may also provide an input to the one or more microcontrollers. Similarly an output from the one or more microcontrollers may be provided to the on/off button to switch the proving unit off in response to the feedback. It will be appreciated that a single or multiple microcontrollers or programmable devices may be used in the modulation circuit, the feedback circuit and the secondary feedback loop.

The low voltage DC input is provided in any of the embodiments provided herein may be provide by a battery or the mains operated will be from the inverter so to allow isolation from the mains. A ground terminal 208 is also provided.

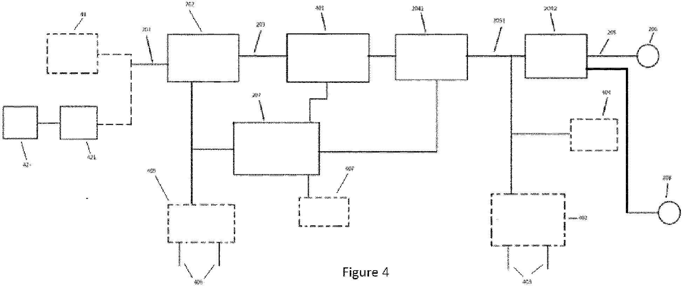

In the embodiment of figure 4 two alternative power supplies are shown, 41, 42. A first power supply is a battery 41 which provides the low voltage DC input. The use of a low voltage battery contributes to the portability of the invention. Alternatively the apparatus may be mains powered 42. In this event an AC to DC inverter 421 is provided to provide the low voltage DC input and also to provide mains isolation. It will be appreciated that while considered portable the present invention is equally applicable to installed units, such as wall mounted units which are static. It will further be appreciated one or both of the battery and AC mains power can be provided for in one unit. Either the batter or mains power can be switchably selected by an operator.

In addition to the features previously described in relation to figures 2 and 3 the embodiment of Figure 4 further shows the additional features of output jacks 403 and 406 which are akin to the output jacks 103 and 104 of Figure 1. For example intermediate AC voltage may be tapped to provide an AC low voltage output 402. In one embodiment the AC low voltage output 402 is provided to jacks 403. This AC low voltage output 402 may for example be 220VAC. It will be appreciated that this will facilitate the testing of an AC voltage meter in this range. A light emitting diode, LED, display or other indicator device 404 which are akin to the LED 107 of Figure 1 is provided to indicate that the output jacks 403 are activated. An additional optional feature shown in figure 4 is the DC voltage output 405 and the output jacks 406. These output jacks 406 are equivalent to the output jacks 106 of figure 1. The DC output voltage 405 is tapped from the modulation circuit to provide the output to the jacks 405. The jacks may be 4mm output jacks. It will be appreciated that such an output will provide the functionality to test a DC voltage meter. A further optional feature of Figure 4 is a further indicator 407. This further indicator may be a LED light or display or the like. This further indicator 407 which are akin to the LED 109. It will be appreciated that this indicator 407 indicates a trip situation.

This indicator indicates the functionality of the feedback circuit. Individual LED or other indicators may be provided. For example, a first indicator may be provided to indicate the functionality of the feedback circuit and a second indicator may be provided to indicate the functionality of the step up circuit. Thus separate indicators may be provided for the feedback circuit and the secondary feedback loop. In the embodiment of figure 4 an optional safety device 401 is provided. The safety device is a cutoff 401. In cooperation with the feedback circuit 207, the cutoff 401 interrupts the power to the step up transformer or blocks the signal to the pulse width modulation.

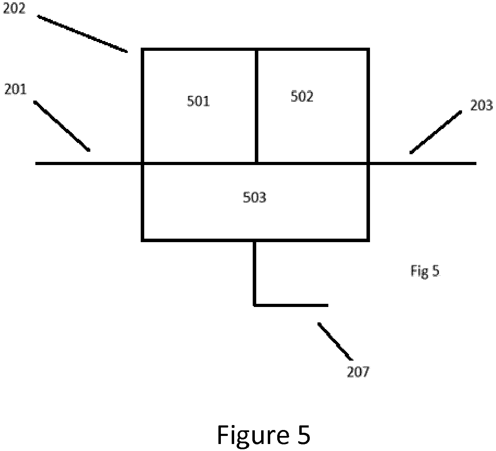

The modulation circuit 202 is described in further detail in figure 5. The modulation circuit includes a control unit 501 (such as a microprocessor or other programmable unit), a frequency selection unit 502 and a safety module 503. The frequency selection unit is configured to provide an optional and selectable frequency output for the portable testing apparatus. This frequency selection unit for example is configurable to provide either a 50 Hz or a 60Hz output. This frequency may be software selectable and programmed via the control unit or hardware selectable via jumpers for example on a printed circuit board. The control unit 501 is configured to modulate the low voltage DC input to the low voltage AC output as described above. In an example and as outlined this is a controlled Pulse Width Modulation. High speed switches, such as power mosfets or IGBTs are used and are switched using the control device to produce the AC output voltage. The modulation circuit further comprises a safety module 503. This safety module 503 may incorporate the feedback circuit 207 and co-operably engages with the control unit by monitoring the power being drawn at the input either from the mains supply or the battery supply as outlined above. The power being drawn at the input is compared to a threshold. If the power level is above the threshold of greater than 10 milli Amps the supply to the step up circuit is de-modulated. It will be appreciated that an increase in the power level may simulate a human touching the electrode in series to ground and thus this safety module provides a safety mechanism to protect an operator. The modulation circuit is implementable on one or more microcontroller or microprocessor, a custom integrated circuit, or other programmable device.

The words "comprises/comprising" and the words "having/including" when used herein with reference to the present invention are used to specify the presence of stated features, integers, steps or components but does not preclude the presence or addition of one or more other features, integers, steps, components or groups thereof.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable sub-combination.

## Claims

1. An apparatus for providing a high voltage, low energy output for proving a high voltage detector for testing voltages greater than 1000VAC; comprising;
an input (201) for receiving a low voltage direct current, DC input;
a modulation circuit (202) arranged to modulate the DC input and provide a first low voltage AC output (203);
a step up circuit (204) having an input for receiving the first low voltage AC output and an output (205) for outputting a second high voltage AC output; and
a feedback circuit configured to monitor the direct current input (201) and interrupt the input to the step-up circuit if an increase in the current input exceeds a threshold.

2. The apparatus of claim 1 wherein the step up circuit (204) comprises a first step-up stage (2041) for receiving the first low voltage AC output and generating an intermediate voltage AC output and a second step-up stage (2042) for receiving the intermediate voltage AC output and generating the second high voltage AC output (205).

3. The apparatus according to claim 1 or 2 wherein the modulation circuit comprises a power transistor and a controller and wherein the controller is configured to control the power transistor to modulate the DC input (201) to provide the first low voltage AC output (203).

4. The apparatus according to claim 3 wherein the modulation circuit (202) is further configured to select an output frequency for the low voltage AC output.

5. The apparatus according to claim 1 wherein the monitoring circuit (202) comprises a switch for interrupting input to the step-up circuit.

6. The apparatus according to claim 1 wherein the low voltage DC input is in the range of 9VDC to 15VDC and preferably 12 VDC.

7. The apparatus according to any previous claim wherein the low voltage DC input is provided by a battery (41), and optionally wherein said battery is rechargeable.

8. The apparatus according to claim 1 wherein the first low voltage AC output is in the range of 7VAC to 12VAC and preferably 9VAC and wherein the second high voltage AC output is in the region of 1000VAC up to 45kV and preferably 1000V.

9. The apparatus of claim 2 wherein the intermediate voltage AC output is in the range of 110VAC to 240VAC.

10. The apparatus according to claim 1 further comprising an alternating current AC input (42) and a converter (421) for converting the AC input to the low voltage DC input.

11. The apparatus according to any previous claim further comprising a contact electrode (206) for providing the high voltage output to a high voltage detector.

12. The apparatus according to any previous claim further comprising a low voltage DC output (403) for outputting a low voltage DC output from the modulation circuit.

13. The apparatus according to any previous claim further comprising one or more indicators (107, 108, 109, 404, 407) for indicating functionality of the apparatus, each indicator comprising one or more light emitting diodes or visual outputs or audible indicator.

14. The apparatus according to claim 13 wherein a first indicator (407) of the plurality of indicators is configured to indicate the functionality of the feedback circuit and a second indicator of the plurality of indicators is configured to indicate the functionality of the step-up circuit.

15. The apparatus according to any previous claim further comprising a timer for monitoring an operation delay and wherein the apparatus is configured to switch off if the operation delay exceeds a threshold.

16. The apparatus according to any previous claim further comprising a second reference electrode 208 for proving two probe voltage detectors.
